# EUROPEAN PATENT APPLICATION

(11) **EP 4 682 566 A1**
(43) Date of publication of application: **21.01.2026**
(21) Application number: 24188980.7
(22) Date of filing: 16.07.2024
(51) Int. Cl.: G01R 31/52

(54) **METHOD FOR LOCATING A GROUND FAULT, A CONTROL UNIT AND AN ENERGY STORAGE SYSTEM**

(71) Applicant: Hitachi Energy Ltd, 8050 Zürich (CH)
(72) Inventor: Bikash Kumar Sahoo, Mohapatra, 756181 BHADRAK (IN); Wikstrom, Kent, 72353 Västerås (SE); Palesjo, Ann, 72356 Västerås (SE); Zhang, Hongyang, 11524 Stockholm (SE)
(74) Representative: AWA Sweden AB

(57) **Abstract**

There is disclosed herein a method (100) for locating a ground fault in an energy storage system (20) comprising a plurality of parallel strings (21). A string comprises a plurality of energy storage units (22) connected in series and an energy storage unit includes one or more energy storage modules (24) and a bypass circuit (26). The method comprises for each string of said energy storage system, identifying (110) an energy storage unit candidate (122) as a potential ground fault location based on a number of energy storage units (116) in the string, a pole unbalance voltage (112) and an energy storage system voltage (114), and determining (120) in which string the ground fault is located by successively bypassing, one string at a time, at least some of the identified energy storage unit candidates and identifying the string for which a deviation from an expected behaviour is measured.

## Description

### Technical field

The present disclosure relates to a method for locating a ground fault in an energy storage system. The present disclosure further relates to a control unit for an energy storage system and an energy storage system.

### Background

The ongoing electrification of various sectors, such as transportation and heating, together with the demand for fossil-free energy sources, such as wind energy and solar energy, leads to a more complex power system with a higher demand for energy. The fossil-free energy sources are often intermittent. Therefore, to balance the supply and demand, energy storage systems are implemented in the power system at a larger scale. To meet such a high energy demand, energy storage units are connected in series and parallel to fulfill the voltage and current requirements.

Ground faults pose significant safety risks, including electrical shock hazards and fire hazards, and can also disrupt the efficient operation of energy storage systems. As such, detecting and addressing ground faults is crucial to ensure the reliability, safety, and performance of energy storage installations. When a ground fault occurs in a large energy storage system with a plurality of energy storage units it may be difficult to find the exact location of the ground fault. There exist methods for detecting the ground fault through for example measurements of the direct current pole voltage.

However, without an efficient method for locating the ground fault when the ground fault is detected, personnel have to manually search for the ground fault which results in long maintenance activities. This may result in long downtimes of the energy storage system. Therefore, a refined methodology for locating a ground fault is required.

### Summary

It is therefore an object of the present disclosure to provide a method for locating a ground fault in an energy storage system that alleviates at least part of the above-mentioned drawbacks. It is for example an object of the present disclosure to provide a method which reduces the downtime of the energy storage system and reduces the difficulty of solving a ground fault in an energy storage system. Further objects of the present disclosure are to provide a control unit which implements the method and an energy storage system comprising said control unit.

According to a first aspect of the present disclosure, a method for locating a ground fault in an energy storage system is provided. The energy storage system comprises a plurality of parallel strings connected between a first direct current, DC, pole and a second DC pole. A string comprises a plurality of energy storage units connected in series and an energy storage unit includes one or more energy storage modules and a bypass circuit for bypassing said energy storage unit within said string. The method comprises, for each string of said energy storage system, identifying a potential ground fault location associated with at least one energy storage unit candidate based on a number of energy storage units in the string, a pole unbalance voltage and an energy storage system voltage, and determining in which string the ground fault is located by successively bypassing, one string at a time, at least some of the identified energy storage unit candidates and identifying the string for which a deviation from an expected behaviour is measured.

According to a second aspect of the present disclosure, a control unit for an energy storage system is provided. The energy storage system comprises a plurality of parallel strings connected between a first direct current, DC, pole and a second DC pole. A string comprises a plurality of energy storage units connected in series and an energy storage unit includes one or more energy storage modules and a bypass circuit for bypassing said energy storage unit within said string. The control unit is configured to, for each string of said energy storage system, identify a potential ground fault location associated with at least one energy storage unit candidate based on a number of energy storage units in the string, a pole unbalance voltage and an energy storage system voltage, and to determine in which string the ground fault is located by successively bypassing, one string at a time, at least some of the identified energy storage unit candidates and identifying the string for which a deviation from an expected behaviour is measured.

According to a third aspect of the present disclosure, an energy storage system is provided. The energy storage system comprises a plurality of parallel strings connected between a first direct current, DC, pole and a second DC pole. A string comprises a plurality of energy storage units connected in series and a control unit according to the second aspect. An energy storage unit includes one or more energy storage modules and a bypass circuit for bypassing said energy storage unit within said string.

Ground faults are a common problem in electrical systems and may be challenging to locate, which increases the maintenance hours to solve the ground fault. The present disclosure provides solutions for locating where the fault is in two steps. A first step of the method uses the combined information of the pole unbalance voltage, energy storage system voltage and the number of energy storage units in each string to determine the potential ground fault location associated with the at least one energy storage unit candidate, i.e. an approximate location of the ground fault, in each string. Generally, the ground fault is located in one of the energy storage units, and in this case only one energy storage unit candidate for each string is determined. However, in a case where the potential ground fault location is determined to be between two energy storage units, both of these energy storage units are determined as the energy storage unit candidate. Only the at least one energy storage unit candidate for each string is provided by the first step. This means that the ground fault is in one of these energy storage unit candidates, i.e. one of the energy storage units, or between two energy storage unit candidates, and that the other energy storage unit candidates in the other strings does not have the ground fault. The respective energy storage unit candidate is one of the respective energy storage units in each string. The potential ground fault location in each string may be determined as an electrical distance from either of the first DC pole and the second DC pole, for example the potential ground fault location is determined to be in the second energy storage unit from the second DC pole, or between the second and third energy storage unit from the second DC pole. The energy storage unit candidate for a string is chosen from the existing energy storage units located in said string.

The second step of the method provides a determination about the string in which the ground fault is located, i.e. a determination of which energy storage unit among the energy storage unit candidates that actually has a ground fault, or in which string the ground fault is. In the second step, the energy storage unit candidate in each string is bypassed, one at a time, to determine whether the string with the ground fault has been located or not. In other words, the method first bypasses the at least one energy storage unit candidate in a first one of the strings, and if it is not detected that the string with the ground fault has been located the energy storage unit candidate of a second one of the strings is bypassed. The energy storage unit candidates may be successively bypassed, one string at a time, until the string in which the ground fault is located has been identified. When it is detected based on the pole unbalance voltage that the string with the ground fault is identified, the ground fault has been located. In other words, it has been detected in which energy storage unit or between which energy storage units, the ground fault is located. Hence, the method may stop before the energy storage unit candidates in the remaining strings have been tested, i.e. bypassed. The pole unbalance voltage and/or the pole to ground voltage will change when said at least one energy storage unit candidate is bypassed in the string with the ground fault. For example, where the ground fault is located between two energy storage unit candidates, the pole unbalance voltage and/or the pole to ground voltage will change when one of these are bypassed, as the electrical distance from the ground fault to the pole changes. In this example, the energy storage unit candidate located closest to one of the poles will be bypassed, as this will result in the most significant change in the pole unbalance voltage and/or the pole to ground voltage.

The ground fault may also be located by successively bypassing all of the identified energy storage unit candidates, one string at a time and thereafter identify in which string the ground fault is located.

At least some of the identified energy storage unit candidates may therefore both be all of the energy storage unit candidates as well as only some of energy storage unit candidates. As discussed above the method may bypass one string at a time until the ground fault is located and in this case the determination of the ground fault location may be completed before all the energy storage unit candidates have been bypassed.

Through these two steps, the method disclosed herein can provide a more efficient way of locating a ground fault in an energy storage system, which reduces the time needed to repair the fault. With the present method, the location of the ground fault can be determined off site without involving personnel on site to search for the ground fault. This results in that the challenge of locating the ground fault is reduced or even mitigated and therefore repairing the ground fault is easier as the ground fault already is located when personnel is on the site. Further, this reduces the engineering skills needed to solve the ground fault. Hence, a wider range of personnel can be used to solve the ground fault and a further reduced maintenance time can be achieved. Reducing the maintenance time results in that the energy storage system can return into operation quicker and hence the availability of energy storage system is increased. A further advantage of determining the ground fault off site through a control unit or an automated method is that the safety of the personnel is increased as the maintenance time on site is reduced.

The pole unbalance voltage and the energy storage system voltage are determined on energy storage system level, which results in that the approximate location for the ground fault in each string is at the same electrical distance from each DC pole. The number of energy storage units used to determine a potential location of the ground fault refers to active energy storage units. In other words, if an energy storage unit is bypassed due to some internal fault, or other reason, the number of energy storage units in the string will be reduced by one. As the ground fault is determined as the electrical distance from each of the DC poles which is the same in each string, the energy storage unit candidate may be different for each string.

Each energy storage unit may be seen as a protection zone of the energy storage system as the bypass circuit allows each energy storage unit to be bypassed. By bypassing one of the protection zones, i.e., the energy storage unit, the string may keep operating without the energy storage modules in that energy storage unit and thereby keep up operation, but with a limited capacity or rating as there is one energy storage unit less.

Generally, the energy storage system is already provided with a ground fault detection system, such that the method may be provided with the information that a ground fault has occurred. An example of such detection system could be the use of DC pole voltage measurements. This information may then act as a start signal for the control unit to perform the method. As an example, when a ground fault is detected, the control unit starts to determine the energy storage unit candidates for determining an approximate location of the ground fault in each string.

The one or more energy storage modules in an energy storage unit may be a plurality of energy storage modules that are arranged in series and/or parallel to each other, depending on the system requirements. The energy storage modules may be serially and/or parallel connected super capacitor or batteries.

Generally, the DC side for large energy storage systems is ungrounded or has a high impedance grounding. For such a large ungrounded energy storage system, if a ground fault occurs, it is generally difficult to find the exact location of ground fault.

With a deviation from the expected behavior is herein meant that it is expected to see a deviation in the pole unbalance voltage and/or the pole to ground voltage when the energy storage unit candidate is bypassed, and this deviation is normal. However, if the studied the pole unbalance voltage and/or the pole to ground voltage deviates more than expected, this indicates that the string with the ground fault has been located.

The deviation from the expected behaviour may be based on a comparison between the measured deviation and a calculated expected deviation or based on a comparison between the measured deviation and a deviation measured for the other strings.

It is expected to see a significant deviation from the expected deviation when the energy storage unit candidate in the string with the ground fault is bypassed. By studying if this deviation occurs it may be determined in which string the ground fault is located without testing to bypass each energy storage unit candidate. However, the method could also test to bypass each energy storage unit candidate and compare the measured deviation when each energy storage unit candidate is bypassed to see which measured deviation that is noticeable different from the others.

The method may further comprise measuring the voltage of the first DC pole and the voltage of the second DC pole. The pole unbalance voltage and the energy storage system voltage may be based on the voltage of the first DC pole and the voltage of the second DC pole.

The pole unbalance voltage may be determined as the sum of the voltage of the first DC pole and the voltage of the second DC pole.

The pole unbalance voltage refers to a voltage unbalance between the first and second DC poles of the energy storage system. In a balanced energy storage system, the absolute values of the voltages at the first and second DC poles are the same. This means that if the voltage at each pole is measured relative to a common reference point, such as ground, the voltages would have equal magnitudes but opposite polarities. In this case, the pole unbalance voltage would be zero. However, if an unbalance occurs between the first and second DC poles, the absolute values of the voltages would not be the same, and the pole unbalance voltage would not be zero.

Based on whether the unbalance voltage is positive or negative, the energy storage unit candidate may be determined. As an example, the first DC pole is seen as a positive DC pole and the second DC pole is seen as a negative DC pole. In this case, a positive pole unbalance voltage would indicate that the ground fault is located closer to the second DC pole, while a negative pole unbalance voltage would indicate that the ground fault is located closer to the first DC pole. Based on the magnitude and the polarity of the pole unbalance voltage, the energy storage candidate in each string may be determined.

The energy storage system voltage may be determined as the difference between the voltage of the first DC pole and the voltage of the second DC pole. The energy storage system voltage may also be referred to as the first DC pole to second DC pole voltage or the voltage across the energy storage system. This voltage represents the total potential difference that the energy storage system can provide or absorb within the DC side.

The deviation from the expected behaviour may be based on at least one of a pole voltage deviation and a pole unbalance voltage change as compared between a post-condition in which the identified energy storage unit candidate is bypassed and a pre-condition in which the identified energy storage unit candidate is not bypassed. This can also be expressed as a deviation observed before and after the energy storage unit candidate is bypassed.

As the pole unbalance voltage and the energy storage system voltage are values that are on the energy storage system level, the change in pole unbalance voltage and the deviation in the energy storage system voltage will be affected when the energy storage unit candidate is bypassed. Thus, if the bypassed energy storage unit candidate in the string is healthy, i.e. not the string with the ground fault, there will be an expected change in the unbalance voltage and the pole voltage as the energy storage system voltage is reduced. However, if the bypassed energy storage unit candidate is in the string having a ground fault, there may be seen a significant, unexpected, change in the pole unbalance voltage from the pre-condition and the post-condition. Further, the pole voltage deviation may be in opposite directions when the energy storage unit candidate, in the string with the actual ground fault, is bypassed, i.e. one of the first and second DC poles will experience a voltage increase and the other one of the first and second DC poles will experience a voltage decrease.

With further parameters for determining in which string the fault is located, the precision and safety of the method will be increased, i.e. only one of the pole voltage deviation and the pole unbalance voltage may be used to determine if the string with the ground fault has been located. However, a better result is obtained if both the pole voltage deviation and the pole unbalance voltage are used for determining if the string with the ground fault has been located.

The method may further comprise discharging the energy storage system when a ground fault is detected and/or located.

Effects and features of the second aspect and the third aspect may be largely analogous to those described above in connection with the first aspect. Embodiments mentioned in relation to the first aspect may be at least largely compatible with the second aspect and the third aspect. It is further noted that the present disclosure relates to all possible combinations of features unless explicitly stated otherwise.

A further scope of applicability of the present disclosure will become apparent from the detailed description given below. However, it should be understood that the detailed description and specific examples, while indicating preferred embodiments of the disclosure, are given by way of illustration only, since various changes and modifications within the scope of the disclosure will become apparent to those skilled in the art from this detailed description.

Hence, it is to be understood that the present disclosure is not limited to the particular parts of the method, control unit and energy storage system described herein. It is also to be understood that the terminology used herein is for the purpose of describing particular embodiments only, and it is not intended to be limiting.

### Brief description of the drawings

The above and other aspects of the present disclosure will now be described in more detail, with reference to the appended figures, wherein:
- Fig. 1: schematically shows an energy storage system comprising a control unit.
- Fig. 2: schematically shows a method for locating a ground fault.
- Fig. 3: schematically shows a flow scheme of the method.

### Detailed description

The present disclosure is described in the following by way of a number of illustrative examples. It will be appreciated that these examples are provided for illustration and explanation only and are not intended to be limiting on the scope of the disclosure.

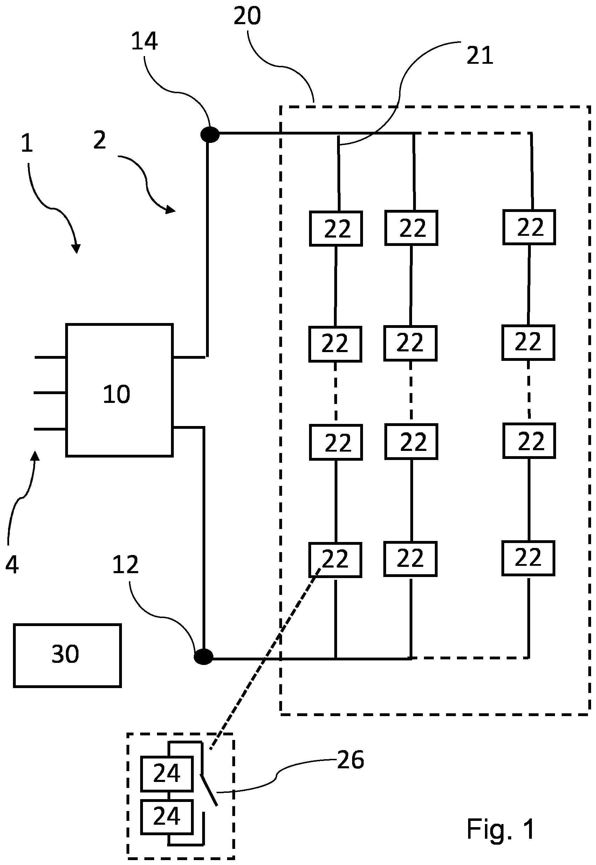

Figure 1 discloses an exemplifying embodiment of a system 1 comprising a converter 10, an energy storage system 20 and a control unit 30. The converter 10 comprises an AC side 4 (which may be a connection to, e.g., an AC grid) and a DC-side 2. The DC-side 2 comprises a first DC pole 12 and a second DC pole 14 between which the energy storage system 20 is connected. The energy storage system 20 comprises a plurality of strings 21 having a plurality of serially connected energy storage units 22. Each string 21 is connected between the first DC pole 12 and the second DC pole 14. Each energy storage unit 22 comprises at least one energy storage module 24 and a bypass circuit 26. In the embodiment depicted in Figure 1, the energy storage unit 22 comprises two energy storage modules 24 connected in series and a bypass circuit 26 connected in parallel to the two serially connected energy storage modules 24. However, the energy storage modules may be connected both in series and parallel, depending on the system requirements. The bypass circuit 26 is provided to allow all of the energy storage modules 24 in an energy storage unit 22 to be bypassed.

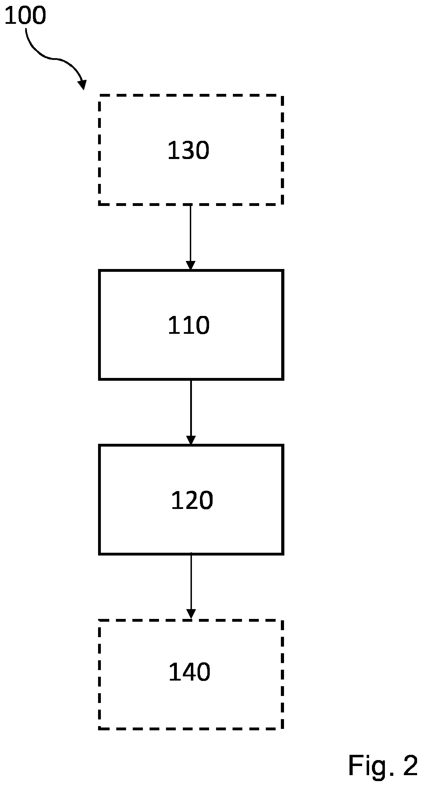

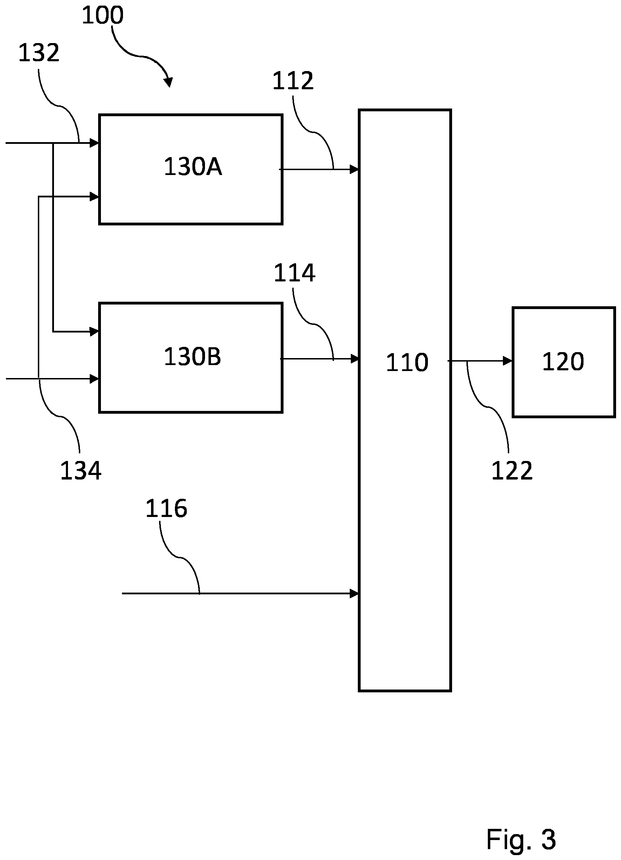

The control unit 30 is provided to control the bypass circuits 26 of the energy storage units 22 and to operate in accordance with the method 100 that will be further described in connection to Figures 2 and 3.

In Figure 2, an overview of the method 100 is illustrated. In Figure 3, a flow scheme illustrates how the method 100 could be implemented. The method 100 comprises two main steps 110 and 120, as illustrated in Figure 2.

For each string 21 of the energy storage system 20, described in connection to Figure 1, the method 100 comprises identifying 110 an energy storage unit candidate 122 as a potential ground fault location based on a number of energy storage units 116 in the string 21, a pole unbalance voltage 112 and an energy storage system voltage 114. The method 100 further comprises determining 120 in which string 21 the ground fault is located by successively bypassing, one string 21 at a time, at least some of the identified energy storage unit candidates 122 and identifying the string 21 for which a deviation from an expected behaviour is measured.

The combined information of the pole unbalance voltage 112, the energy storage system voltage 114 and the number of energy storage units 116 can be used to identify an energy storage unit candidate 122 for each string 21. This means that an approximate location of the ground fault in each string 21 can be determined. To detect in which string 21 the ground fault is located, the second step is performed, in which the identified energy storage unit candidates 122 are bypassed, one at a time. In one example, in the method 100, the energy storage unit candidate in a first one of the strings is first bypassed, and if it is detected that the string with the ground fault has not been detected, the energy storage unit candidate of a second one of the strings is bypassed. This is repeated for each string 21 until the string with the ground fault is located. In another example, this may be repeated for each string 21 and a determination may then be made as to which string is the string containing the ground fault once the measurements have been made for all strings.
protection zone may be of different sizes within a system and between different applications, i.e., the number of energy storage modules 24 in the protection zone may vary.

Generally, the energy storage system 20 is already provided with a ground fault detection system (not shown), such that the method 100 may be provided with the information that a ground fault has occurred. This information may then act as a start signal (or trigger) for the control unit 30 to perform the method 100.

Generally, the DC side for large energy storage systems is ungrounded or has a high impedance grounding. For such a large ungrounded energy storage system, if a ground fault occurs, it is generally difficult to find the exact location of ground fault.

As illustrated in Figure 2, the method 100 may further comprise measuring 130 the voltage 132 of the first DC pole 12 and the voltage 134 of the second DC pole 14. The pole unbalance voltage 112 and the energy storage system voltage 114 can be based on the voltage 132 of the first DC pole 12 and the voltage 134 of the second DC pole 14. These additional steps are further illustrated in Figure 3. The pole unbalance voltage 112 and the energy storage system voltage 114 are determined at an energy storage system level, which results in that the potential location of the ground fault in each string 21 may be at the same level.

In Figure 3, it is illustrated how the pole unbalance voltage is determined 130A based on the first DC pole voltage 132 and the second DC pole voltage 134. The sum of the first DC pole voltage 132 and the second DC pole voltage 134 may be used to determine the pole unbalance voltage 112. In a balanced energy storage system, the absolute values of the voltages at the first and second DC poles are the same. As the polarity of the first DC pole voltage 132 and the second DC pole voltage 134 usually are opposite, the sum of the first and second DC pole voltages 132, 134 should be zero during normal operation. Based on whether the pole unbalance voltage 112 is positive or negative, the energy storage unit candidate 122 may be determined. As an example, if the first DC pole 12 is seen as a positive DC pole and the second DC pole 14 is seen as a negative DC pole, a positive pole unbalance voltage 112 indicates that the ground fault is located closer to the second DC pole 14, while a negative pole unbalance voltage 112 indicates that the ground fault is located closer to the first DC pole 12. Based on the magnitude and the polarity of the pole unbalance voltage 112, a location of the energy storage unit candidate 122 in each string 21 may be determined.

The energy storage system voltage 114 may be determined 130B as the difference between the voltage 132 of the first DC pole 12 and the voltage 134 of the second DC pole 14.

The pole unbalance voltage 112, the energy storage system voltage 114 and the number of energy storage units 116 are used as input for identifying 110 the energy storage unit candidate 122 for each string. The energy storage unit candidates 122 is then used as input for determining 120 in which string the ground fault is located.

One way of determining in which string 21 the ground fault is located is by studying the change on at least one of a pole voltage deviation and a pole unbalance voltage change between a post-condition in which the identified energy storage unit candidate is bypassed and a pre-condition in which the identified energy storage unit candidate is not bypassed.

As the pole unbalance voltage 112 and the DC pole voltages 132, 134 are values that are obtained at the energy storage system level, the change in pole unbalance voltage 112 and the deviation in the DC pole voltages 132, 134 will be affected when one energy storage unit candidate 122 is bypassed. Thus, if the string 21 is healthy, i.e. not the one with the ground fault, there will be an expected change in the pole unbalance voltage 112 and/or the pole voltages 132, 134 as the energy storage system voltage 114 is reduced when the energy storage unit candidate 122 is bypassed. However, if the bypassed energy storage unit candidate 122 is the one having a ground fault, a more significant, unexpected, change in the pole unbalance voltage 112 between the pre-condition and the post-condition will be detected. The change will be larger than when an energy storage unit candidate 122, in a string 21 not having the ground fault, is bypassed. Further, the deviation in pole voltages 132, 134 may be in opposite directions, i.e. one of the first and second DC poles 12, 14 will experience a voltage increase and the other one of the first and second DC poles 12, 14 will experience a voltage decrease when the energy storage candidate 122, in the string 21 having the ground fault, is bypassed. The described change in pole voltage and pole unbalance voltage are both signs that the energy storage candidate 122, in the string 21 having the ground fault, has been bypassed and may be used on their own or combined to increase the accuracy of the determination.

While the present disclosure is susceptible to various modifications and alternative forms, specific examples are shown and described in relation to the drawings, with a view to clearly explaining the various advantageous aspects of the present disclosure. It should be understood, however, that the detailed description herein and the drawings attached hereto are not intended to limit the disclosure to the particular form disclosed. Rather, the intention is to cover all modifications, equivalents, and alternatives falling within the scope of the following claims, including the possible combination of various elements of these specific examples.

## Claims

1. A method (100) for locating a ground fault in an energy storage system (20) comprising a plurality of parallel strings (21) connected between a first direct current, DC, pole (12) and a second DC pole (14), wherein a string comprises a plurality of energy storage units (22) connected in series and an energy storage unit includes one or more energy storage modules (24) and a bypass circuit (26) for bypassing said energy storage unit within said string, the method comprising:
for each string of said energy storage system, identifying (110) a potential ground fault location associated with at least one energy storage unit candidate (122) based on a number of energy storage units (116) in the string, a pole unbalance voltage (112) and an energy storage system voltage (114), and
determining (120) in which string the ground fault is located by successively bypassing, one string at a time, at least some of the identified energy storage unit candidates and identifying the string for which a deviation from an expected behaviour is measured.

2. The method according to claim 1, wherein the deviation from the expected behaviour is based on at least one of a pole voltage deviation and a pole unbalance voltage change as compared between a post-condition in which the identified energy storage unit candidate is bypassed and a pre-condition in which the identified energy storage unit candidate is not bypassed.

3. The method according to claim 1 or 2, wherein the deviation from the expected behaviour is based on a comparison between the measured deviation and a calculated expected deviation or based on a comparison between the measured deviation and a deviation measured for the other strings.

4. The method according to any one of the preceding claims, wherein in which string the ground fault is located is determined by successively bypassing the identified energy storage unit candidates, one string at a time, until the string in which the ground fault is located has been identified.

5. The method according to any one of claims 1 to 3, wherein in which string the ground fault is located is determined by successively bypassing all of the identified energy storage unit candidates, one string at a time.

6. The method according to any one of the preceding claims, further comprising measuring (130) the voltage (132) of the first DC pole and the voltage (134) of the second DC pole, and wherein the pole unbalance voltage (112) and the energy storage system voltage (114) are based on the voltage of the first DC pole and the voltage of the second DC pole.

7. The method according to claim 6, wherein the pole unbalance voltage is determined (130A) as the sum of the voltage of the first DC pole and the voltage of the second DC pole.

8. The method according to claim 6 or 7, wherein the energy storage system voltage is determined (130B) as the difference between the voltage of the first DC pole and the voltage of the second DC pole.

9. The method according to any one of the preceding claims, further comprising bypassing (140) the energy storage unit in which the ground fault is located.

10. A control unit (30) for an energy storage system (20) comprising a plurality of parallel strings (21) connected between a first direct current, DC, pole (12) and a second DC pole (14), wherein a string comprises a plurality of energy storage units (22) connected in series and an energy storage unit includes one or more energy storage modules (24) and a bypass circuit (26) for bypassing said energy storage unit within said string, the control unit being configured to:
for each string of said energy storage system, identify a potential ground fault location associated with an energy storage unit candidate based on a number of energy storage units in the string, a pole unbalance voltage, and an energy storage system voltage, and
determine in which string the ground fault is located by successively bypassing, one string at a time, at least some of the identified energy storage unit candidates and identifying the string for which a deviation from an expected behaviour is measured.

11. The control unit according to claim 10, wherein deviation from the expected behaviour is determined based on at least one of a pole voltage deviation and a pole unbalance voltage change as compared between a post-condition in which the identified energy storage unit candidate is bypassed and a pre-condition in which the identified energy storage unit candidate is not bypassed.

12. The control unit according to claim 10 or 11, wherein the deviation from the expected behaviour is based on a comparison between the measured deviation and a calculated expected deviation or based on a comparison between the measured deviation and a deviation measured for the other strings.

13. The control unit according to any one of claims 10 to 12, wherein in which string the ground fault is located is determined by successively bypassing the identified energy storage unit candidates, one string at a time, until the string in which the ground fault is located has been identified.

14. The control unit according to any one of claims 10 to 12, wherein in which string the ground fault is located is determined by successively bypassing the identified energy storage unit candidates, one string at a time,

15. An energy storage system (20) comprising:
a plurality of parallel strings (21) connected between a first direct current, DC, pole (12) and a second DC pole (14), wherein a string comprises a plurality of energy storage units (22) connected in series and an energy storage unit includes one or more energy storage modules (24) and a bypass circuit (26) for bypassing said energy storage unit within said string, and
a control unit (30) according to any one of claims 10 to 14.
